# EUROPEAN PATENT APPLICATION

(11) **EP 2 551 311 A1**
(43) Date of publication of application: **30.01.2013**
(21) Application number: 12178096.9
(22) Date of filing: 26.07.2012
(51) Int. Cl.: C09D 183/04, H01L 31/0216

(54) **Coating with carbon nanotubes for low-cost photovoltaic modules and corresponding method of application**

(30) Priority: 29.07.2011 IT TO20110699
(71) Applicant: Tecnocarbon ant S.r.l., 10121 Torino (IT)
(72) Inventor: Ansaldi, Roberto, 10026 Santena (Torino) (IT)
(74) Representative: Buzzi, Franco

(57) **Abstract**

A coating for photovoltaic panels, characterized by a film with high mechanical performance, and resistance to climatic and environmental interactions that includes a functional inorganic polymer with high electrical conductivity and incorporates carbon nanotubes, to be applied on amorphous silicon for solar cells or on single-cell photovoltaic panels.

## Description

### Field of the invention

The present invention relates in general to the production of electrically connected silicon photovoltaic modules.

### Description of the relevant art

The production of energy has always occupied an important place in the economy and development, both at a national level and at an international level. It is general knowledge that a high energy consumption is a necessary condition for obtaining more products and services, in short, a high quality of life. Unfortunately, every energy source presents, to a greater or lesser extent, its own difficulties and every country now has to evaluate the health and environmental risks connected to the use of any energy source. For this reason and on account of the continuous increase in the cost of oil and other fossil fuels in industrialized countries, research has been concentrating on renewable energy sources, such as solar energy, hydroelectric energy, wind power, energy from the tides, wave motion, marine currents, the difference in temperature between deep marine waters and surface waters, biomass, geothermal energy, the energy produced from urban waste, and so forth.

In particular, the most promising alternative energy source is solar energy, i.e., the energy that throughout the day the Sun sends to the Earth in the form of light. The light emitted by the Sun assumes a particular form (solar spectrum) of the electromagnetic spectrum, which varies according to the frequency and is maximum in the so-called "visible spectrum", or where the human eye sees, i.e., between 380 and 830 nm. The main purpose is hence to develop a technology that will be able to exploit the majority of the solar spectrum at minimum cost.

Silicon technology is the dominant one, and solar cells currently on the market are based upon polycrystalline-silicon or monocrystalline-silicon technology. Polycrystalline-silicon solar cells are less efficient than monocrystalline-silicon solar cells, but obviously the production costs are lower. Available on the market today are multicell solar panels with cells that use monocrystalline or polycrystalline silicon with a selective doping of boron, arsenic, phosphorus, or other elements.

The photovoltaic effect of all the cells on the market is obtained via the PN junction, which is formed by two areas: one with an excess of electrons (n layer) and one with an excess of holes (p layer). The excesses of electrons and holes are obtained with various techniques. The term "junction" refers to the region and can be considered as the boundary region between blocks of type P and blocks of type N and is without free charge carriers. At the two sides of the junction there is a constant difference of potential, referred to as built-in voltage, and is obtained via doping of the silicon.

Some experimental applications of carbon nanotubes (CNTs) on silicon have produced results in terms of performance equivalent to those of doped monocrystalline silicon, but with higher costs.

The photovoltaic modules thus obtained are made up of cells electrically connected together, with the PN junction guaranteed by the silicon. Typically, the electrical connection between the cells is obtained by means of a surface wiring with a grid of conductive material that channels the electrons. Normally, each individual cell is connected to the others by means of metal straps so as to form electrical connections in series and in parallel.

To produce the photovoltaic cell, laid on a supporting substrate, made of an insulating material with poor thermal expansion, such as hardened glass, are a thin layer of vinyl acetate and then the array of cells pre-connected by means of the aforementioned straps. A second layer of acetate and a transparent material that functions as mechanical protection for the cells, also in this case in general constituted by hardened glass, are then laid. After a process of die-casting, the electrical terminations of the straps are closed in a sealed terminal board generally fixed to the supporting substrate, thus completing the sandwich structure of the photovoltaic module.

### Object and summary of the invention

The object of the present invention is to simplify production of photovoltaic modules of this sort reducing the costs thereof and increasing the performance, also enabling, albeit not exclusively, the use of amorphous instead of monocrystalline or polycrystalline silicon.

This is obtained with the adoption of a coating with the following characteristics:
- high photovoltaic efficiency;
- high electrical conductivity;
- high mechanical performance; and
- high resistance to atmospheric and environmental conditions;
said coating incorporating carbon nanotubes.

According to the invention, the above object is achieved thanks to the adoption of a high-performance and low-cost coating with photovoltaic functions for solar panels according to Claim 1.

### Description of embodiments of the invention

The coating according to the present invention is characterized in that it consists of a film including a functional inorganic polymer with high electrical conductivity, high dimensional stability and high thermal resistance that incorporates single-walled carbon nanotubes (SWNTs).

The coating according to the invention enables production, in a relatively simple and inexpensive way, of an extended heterojunction with a further dual advantage: the properties of carbon nanotubes, more conveniently (albeit not exclusively) single-walled carbon nanotubes (SWNT), combined with silicon make it in fact possible to increase the value of IPCE (incident photon-to-current efficiency), namely, the efficiency of conversion of the incident light into current, and simultaneously:
- to exploit amorphous silicon, which has production costs that are decidedly lower than polycrystalline and monocrystalline silicon and that can be evaporated and deposited on various and more versatile substrates, such as plastic;
- to avoid the need to "dope" the silicon substrate, which involves a very costly process and with marked environmental impact in so far as the "dopant" substances are highly pollutant.

The cells of amorphous silicon with SWNTs and those of doped silicon present on the other hand an equivalent spectral sensitivity.

The use of the photovoltaic coating together with amorphous silicon thus represents an important evolution of photovoltaic panels, both from the design standpoint and from the performance standpoint in so far as it presents as a product having higher of performance higher than traditional ones but at a decidedly lower industrial cost, which considerably attenuates the impact in terms of investment, with evident benefits as regards the times of economic return on investment.

### Composition and methodology for the preparation of the photovoltaic coating

According to a preferred embodiment, the coating according to the invention can present, prior to its polymerization, the following composition:
- monomers chosen in the class of organo-functional silanes: 30 wt%
- amine (pH > 8): 3 wt%
- base solution containing carbon nanotubes: 6 wt%
- water: 51 wt%
- surfactant: 0.1 wt%
- solvent: 9.9 wt%

The idea underlying said preferred formulation is to enable, when the formulation is applied on the substrate, homogeneous distribution of the SWNTs over the surface exposed to solar radiation, provision of a film of a calibrated thickness (these being elements fundamental for optimizing the efficiency of the photovoltaic system), and reduction to a minimum of the insulating effect of the binder necessary for obtaining adherence of the particles of said coating to the substrate. Traditional binders, in fact, are mainly constituted by organic molecules, which, like plastic materials, are electrically insulating. To reduce to a minimum this effect the formulation of the coating according to the invention hence uses the aforesaid monomers of organo-functional silanes, which, after adequate polymerization, convert into an inorganic polymer having an excellent electrical conductivity that is decidedly to that of organic polymers.

A further advantage deriving from the use of the inorganic polymer lies in the extremely high dimensional stability and resistance both to the temperature range of -40°C to +120°C and to sunlight (UV + IR) in order to avoid any surface degradation, or any variation of colour that could reduce the photovoltaic efficiency of the SWNTs, unlike any organic polymer that would tend to degrade over more or less long times and to lose its initial properties, becoming ?opaque, cracking, and undergoing a reduction in transparency to the point where the PN junction is impaired.

The concentration of carbon nanotubes in the base solution of the composition is defined according to the photovoltaic properties optimal for a given final thickness of the coating: typically, with optimal thicknesses of the film of coating, the concentration of carbon nanotubes in the base solution is in the region of 10 wt%. Said concentration will also be a function of the substrate on which the coating will be applied.

With the application of the photovoltaic coating on the amorphous silicon values of IPCE, i.e., the ratio between the current carriers collected and the number of incident photons, are obtained higher by a factor 10⁵ (100,000) than those obtained from traditional cells. Moreover, there is a shift to the infrared in the IPCE, in particular in the 450 to 650-nm range.

In fact the excellent results, in terms of percentage optical transmission at 550 nm, are a function of the following fundamental characteristics present in the photovoltaic coating:
- the concentration of SWNTs in the base solution;
- the thickness of the coating on the supporting substrate;
- the constant distribution of the SWNTs on the surface exposed to solar radiation; and
- the degree of purity of the carbon nanotubes.

As regards organo-functional monomers of the class of the silanes, these must be conveniently selected from:
- aminoalkyl-functional silanes;
- diamino-functional silanes; and
- epoxy-functional silanes,
in order to guarantee high mechanical performance and resistance to environmental climatic conditions. The inorganic polymers that derive therefrom consist of (-Si-O-Si-O-Si-O-)ₙ chains, with the functional groups that cling to the silicon atoms and offer significant classes of resistance and stability present in the, even extreme, conditions of use of the photovoltaic panel.

In the base solution, the SWNTs are present, with degree of purity higher than 99.99%, prepared and treated as follows:
10. purification in low-voltage electrical field in liquid to eliminate the impurities in any case present on the surface;
20. high-frequency sonication (sonic cavitation) in water thermostatted at constant temperature.

These two steps are fundamental for obtaining optimal photovoltaic performance.

### Cycle of application of the photovoltaic coating on amorphous silicon

The method of application of the coating on amorphous silicon according to the invention conveniently comprises, starting from the composition described above, the following steps:
10. keeping the photovoltaic coating at 20°C for twelve hours prior to dispensing;
20. detecting the viscosity with a viscosimeter or with a Ford cup;
30. without any dilution, keeping the photovoltaic coating mechanically stirred for at least 30 min at 20°C in an ISO 6 class 1,000 cleanroom;
40. dispensing via ink-jet with piezoelectric ejection system with resulting surface density of 15 - 17 g/m², in an ISO 6 class 1,000 cleanroom;
50. flashing for 7 m at a temperature of 20°C in an ISO 6 class 1,000 cleanroom;
60. polymerizing at 220°C +/- 2°C for 30 min, with an ascending ramp of the temperature detected on the element of less than 1°C/s;

The photovoltaic coating has no limits in terms of pot life.

The mechanical performance and resistance to the following tests:
- adhesion (cross-cut test)
- peeling
- blistering (test in water at 90°C)
- resistance to accelerated yellowing (UVcon)
- resistance to rapid variations in temperature (cycles -40°C + 120°C)
revealed a decay in efficiency that was decidedly less than the decay present, given the same tests, on existing solutions without any surface protection (glass), i.e., with direct contact of the coating with the agents (water, UV, heat).

Deposition of the mix on the substrate prepared and active for reception is typically carried out with technologies similar to ink-jet printing via piezoelectric ejection. This technology enables extremely precise application and makes it possible to obtain a film of coating of constant thickness. The quantity of mix applied is a function of the concentration of the carbon nanotubes and of the dispensing thickness, the surface-density reference value of which may be typically in the region of 15-17 g/m². Dispensing must normally take place in a pressurized chamber at controlled temperature and humidity.

The characteristics of the film of coating thus applied are such as to guarantee the following advantageous effects:
- minimum thickness of application;
- excellent adhesion between coating and metal, glass, or thermoplastic substrates (even without activation);
- excellent resistance to abrasion;
- excellent resistance to action of UV-IR radiation (absence of yellowing or dulling);
- excellent resistance to chemical agents and to cleaning products (surfactants, alcohol, etc.);
- excellent resistance to sharp variations in temperature and humidity.

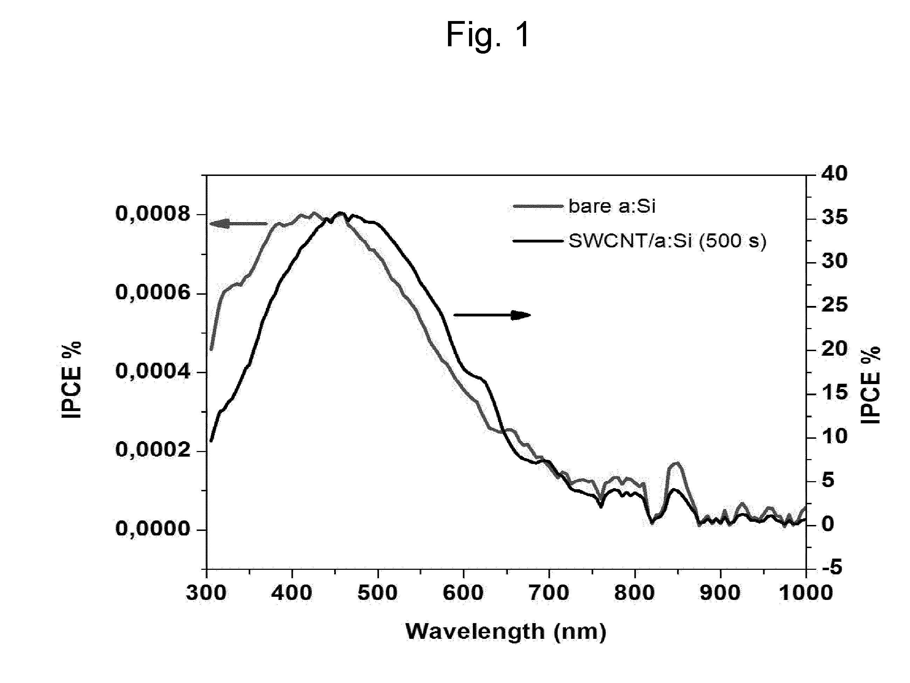

The photovoltaic coating according to the invention is based upon the PN junction formed by amorphous silicon and the treated single-walled carbon nanotubes (SWNTs) that are deposited, as mentioned, on its surface to form an extended heterojunction. In this way, a dual advantage is obtained with respect to the technologies based upon the doping of monocrystalline or polycrystalline silicon. In fact, with the photovoltaic coating according to the invention IPCE values are obtained, on amorphous silicon, higher by a factor 10⁵ than those obtained from traditional cells, slightly higher than those existing on monocrystalline silicon (Figure 1), which results in an overall greater efficiency (21-23%) of the system as compared to monocrystalline panels (17-20%) and polycrystalline panels.

This is obtained on account of two fundamental factors:
- the preventive treatment of the SWNTs; and
- the particular formulation of the coating, halfway between a paint and an ink, calibrated for optimizing both the IPCE performance and the efficiency of the photovoltaic system on the amorphous silicon alone and bestowing on the coating high performance in terms of strength and resistance to atmospheric agents.

In fact, the high photovoltaic performance is given by:
- the constant distribution of the SWNTs over the surface exposed to radiation;
- use of SWNTs with a degree of purity of 99.99% and further purified from the presence of foreign bodies on their surface; and
- thickness calibrated according to the application (larger or smaller thicknesses of the film determine a decay of the IPCE values)

### Advantages of the photovoltaic coating

The advantages are both direct and indirect.

### 1. Direct advantages

### 1A) Higher efficiency

Production of a photovoltaic system with an efficiency higher by 3-4% approximately than the best performance of monocrystalline silicon, i.e., 21-23% as against 17-20%.

### 1B) Lower costs

Possibility of a considerable reduction of the industrial costs (18% on average) in so far as it enables:
I. use of amorphous silicon is with decidedly lower costs for the raw material;
II. possibility of evaporation and deposition on different, more versatile and less costly, substrates (such as plastic and other materials);
III. elimination of the need to "dope" the silicon, which is undoubtedly a costly process; and
IV. reduction of the costs for managing environmental safety.

All this reduces the EPBT (Energy Pay Back Time) indicator by 20% approximately as compared to existing solutions, given the same percent mark-up, as emerges from the table appearing below.

| **Parameter** | **Monocrystalline silicon** | **Polycrystalline silicon** | **Amorphous silicon** | **Photovoltaic coating + Amorphous silicon** |
|---|---|---|---|---|
| Efficiency (%) | 17 - 20 | 12 - 15 | 6 - 9 | 21- 23 |
| EPBT (year) | 2 | 1.7 | 1.5 | 1.1 |
| Total industrial cost (€/ W) | 0.68 | 0.62 | 0.51 | 0.32 |

The possibility of obtaining values of PN junction without having to dope the silicon with boron, arsenic, or other pollutant substances enables development of processes without the use of pollutant substances and hence with processes having low environmental impact in addition to a lower consumption of energy, as compared to traditional processes.

### 2. Indirect advantages

The performance levels and the reduction in costs make it possible to produce a photovoltaic panel consisting of just one photovoltaic cell (single-cell of standard or variable dimensions) and hence to achieve the following further economic advantages, as compared to existing solutions that envisage a photovoltaic panel constituted by an ensemble of individual photovoltaic cells (multicell panel):
- reduction of the components of the ensemble;
- lower external resistance, with improvement of the relation between incident radiation on the panel and the photocurrent;
- larger area exposed to radiation owing to elimination of the surface not receptive for photovoltaic purposes present in the multicell versions; and
- higher reliability of the system deriving from the lower possibility of failure of just one element (one cell) as compared to multicell versions, and hence lower impact of after-sales costs.

It has been calculated how, given the same efficiency, the possibility of operating with a single-cell panel as compared to a homologous multicell panel reduces the industrial cost by 31% (with single cell and photovoltaic coating = 0.32 €/W full cost) as compared to multicell polycrystalline versions.

Of course, the details of the coating and of the method for its application may vary widely with respect to what has been described and illustrated herein, without thereby departing from the scope of the present invention as defined in the ensuing claims. Thus, for example, the use of multiwall carbon nanotubes may be envisaged, instead of single-walled carbon nanotubes, which are less costly.

## Claims

1. A coating having high photovoltaic efficiency, high electrical conductivity, high mechanical performance and resistance to environmental climatic conditions, incorporating carbon nanotubes, said coating being **characterized by** the adoption of a particular high-performance low-cost polymer-based formulation applied, following a pre-treatment cycle of single-walled carbon nanotubes (SWNT), on amorphous silicon for solar panels.

2. The coating according to Claim 1, **characterized in that**, prior to its polymerization, it has the following composition:
- monomers chosen in the class of organo-functional silanes: 30 wt%
- amine (pH > 8): 3 wt%
- base solution containing the carbon nanotubes: 6 wt%
- water: 51 wt%
- surfactant: 0.1 wt%
- solvent: 9.9 wt%.

3. The coating according to Claim 2, **characterized in that** the concentration of carbon nanotubes in the base solution is in the region of 10 wt%.

4. The coating according to Claim 2, **characterized in that** the monomers are selected from: aminoalkyl-functional silanes; diamino-functional silanes; epoxy-functional silanes.

5. The coating according to any one of the preceding claims, **characterized in that** it has a thickness in the region of 12-20 µm.

6. The coating according to any one of the preceding claims, **characterized in that** the carbon nanotubes are single-walled carbon nanotubes (SWNTs).

7. The coating according to Claim 6, **characterized in that** the 99.99% single-walled carbon nanotubes (SWNTs) are purified at a low voltage in liquid solution at constant temperature and for a pre-set time.

8. The coating according to Claim 7 or 8, **characterized in that** the SWNTS are sonicated at high frequency in liquid solution to guarantee a given grain size and constant distribution on the film of the coating exposed to solar radiation.

9. Use of a coating according to one or more of the preceding claims for application on amorphous-silicon solar panels.

10. Use of a coating according to one or more of Claims 1 to 8, for application also on polycrystalline-silicon solar cells.

11. A method for application of a coating for photovoltaic modules according to one or more of Claims 2 to 9, **characterized in that** it comprises the following operations:
- preparing and storing the aforesaid composition for a period, prior to application, of approximately 12 h at 20°C;
- detecting the viscosity with a viscosimeter or a Ford cup;
- mixing the composition uniformly by mechanical stirring at room temperature and pressure;
- depositing a layer of the composition on amorphous silicon using ink-jet technology, in an ISO 6 cleanroom;
- carrying out flashing of the layer of the composition deposited for a period of 7 min in an ISO 6 cleanroom; and
- polymerizing the layer of the composition deposited at a temperature of 220°C for a period in the region of 30 min, with an ascending ramp of temperature detected on the element of less than 1°C/s;

12. The method according to Claim 11, **characterized in that** the composition is deposited using ink-jet technology in a pressurized environment with controlled temperature and humidity to obtain a constant thickness of the film, preferably comprised between 12 and 20 µm in an ISO 6 cleanroom.

13. The method according to Claim 11 or Claim 12, **characterized in that** the coating is applied to amorphous-silicon or polycrystalline-silicon photovoltaic cells.

14. The method according to any one of Claims 11 to 13, **characterized in that** the carbon nanotubes are single-walled carbon nanotubes (SWNTs).

15. The method according to any one of Claims 11 to 14, **characterized in that** the coating is applied on a single-cell photovoltaic panel.
